# EUROPÄISCHE PATENTSCHRIFT

(11) **EP 2 725 363 B1**
(45) Veröffentlichungstag und Bekanntmachung des Hinweises auf die Patenterteilung: **03.12.2014**
(21) Anmeldenummer: 12189810.0
(22) Anmeldetag: 24.10.2012
(51) Int. Cl.: G01R 1/04, G01R 1/067

(54) **Kontaktfeder für einen Prüfsockel für die Hochstrom-Prüfung eines elektronischen Bauteils**
Contact spring for a test socket for the high power testing of an electronic component
Ressort de contact pour un support de test pour le contrôle à haute intensité d'un composant électronique

(43) Veröffentlichungstag der Anmeldung: 30.04.2014
(73) Patentinhaber: Multitest elektronische Systeme GmbH, 83026 Rosenheim (DE)
(72) Erfinder: Gschwendtberger, Gerhard, 83098 Brannenburg (DE); Leikermoser, Volker, 83229 Aschau (DE); Petermann, Manuel, 83022 Rosenheim (DE); Frey, Marcus, 83233 Bernau (DE)
(74) Vertreter: Dilg, Haeusler, Schindelmann Patentanwaltsgesellschaft mbH

(56) Entgegenhaltungen:
- DE-A1- 19 533 272
- US-A1- 2007 072 479
- US-A1- 2010 120 269

## Beschreibung

Die Erfindung betrifft eine Kontaktfeder für einen Prüfsockel für die Strom-Prüfung, insbesondere Hochstrom-Prüfung, eines elektronischen Bauteils nach dem Oberbegriff von Anspruch 1 und einen Prüfsockel nach dem Oberbegriff von Anspruch 4.

Elektronische Bauteile werden üblicherweise bestimmten Tests unterzogen, um ihre elektrischen Funktionen zu überprüfen. Es sind hierfür mehrere Möglichkeiten bekannt geworden. Beispielsweise werden die elektronischen Bauteile noch vor ihrer Vereinzelung auf dem Substrat geprüft. Oder es wird ein Träger vorgesehen, auf dem eine Vielzahl der elektronischen Bauteile befestigt werden.

Der Träger oder das Substrat wird dann einem sogenannten Handler übergeben. Der Handler weist einen normalerweise feststehenden Testkopf auf, mit dem ein ebenfalls feststehender Prüfsockel verbunden ist. Der Träger oder das Substrat wird gegenüber dem Prüfsockel exakt positioniert. Es kann ein Prüfsockel verwendet werden, der alle elektronischen Bauteile gleichzeitig kontaktiert und prüft, oder es werden nur bestimmte Bauteilgruppen gleichzeitig, oder sogar jedes Bauteil einzeln geprüft. Wenn nicht alle elektronischen Bauteile gleichzeitig geprüft werden, muss der Träger oder das Substrat nach jedem Prüfschritt neu positioniert werden.

In bestimmten Fällen werden elektronische Bausteine aber auch einzeln an einen Handler übergeben und dort auch vereinzelt weiter verarbeitet. Die einzelnen Bauteile werden hier in ein sogenanntes Nest eingesetzt und in diesem gegenüber dem Prüfsockel positioniert.

Es sind elektronische Bauteile bekannt geworden, die hohe Ströme schalten und leiten können. Solche Bauteile werden z. B. in Stromversorgungen für Anlagen mit hohem Strombedarf, schnellen Schaltintervallen und möglichst geringen Verlusten benötigt.

Für die Hochstrom-Prüfung eines solchen elektronischen Bauteils werden oft Prüfsockel verwendet, die für einige zu kontaktierende Kontaktflächen des elektronischen Bauteils zwei Kontaktfedern aufweisen. Dabei dient eine der Kontaktfedern der Beaufschlagung des elektronischen Bauteils mit dem Schaltsignal und die andere der Einspeisung des zu schaltenden Stroms.

Da beide Kontaktfedern eine einzige Kontaktfläche kontaktieren, müssen sie relativ eng nebeneinander angeordnet sein. Andererseits benötigen sie eine hohe Stromfestigkeit. Es stehen sich hier also ein kleiner vorhandener Bauraum und ein möglichst großer Durchmesser mit möglichst großer Oberfläche für eine hohe Stromfestigkeit und eine gute Wärmeabfuhr gegenüber.

Bekannte Kontaktfedern sind aus einem Federblech gefertigt und weisen demzufolge zwei gleiche Seitenflächen auf, während ihre Stärke überall konstant ist. Die Stärke des Federblechs richtet sich insbesondere nach dem Abstand und der Größe der Kontaktflächen des elektronischen Bauteils. Bei elektronischen Bauteilen mit sehr vielen, kleinen und nahe beieinander liegenden Kontaktflächen müssen folglich Kontaktfedern mit geringer Stärke verwendet werden, da sich die nebeneinander angeordneten Kontaktfedern ansonsten gegenseitig beeinflussen oder sogar berühren würden. Aufgrund der sich widersprechender Anforderungen von Größe und Stromfestigkeit weisen insbesondere herkömmliche Kontaktfedern für die Hochstrom-Prüfung von elektronischen Bauteilen mit vielen, eng beieinander liegenden Kontaktflächen meist nur eine geringe Standzeit auf.

US 2007/072479 A1, US 2010/120 269 A1, DE 195 33 272 A1 offenbaren verschiedene Prüfkontakte.

Die Federkraft der Kontaktfedern wird zum einen durch ihre Materialstärke und zum anderen durch die geringste Dicke des Federhebels bestimmt. Da die Federkraft in etwa immer gleich dimensioniert sein sollte, wird diese geringste Dicke des Federhebels bei Kontaktfedern mit größerer Materialstärke kleiner als bei Kontaktfedern mit weniger Materialstärke gewählt.

Der Erfindung liegt die Aufgabe zugrunde, eine Kontaktfeder für einen Prüfsockel für die Strom-Prüfung, insbesondere Hochstrom-Prüfung, eines elektronischen Bauteils so zu gestalten, dass die Standzeit der Kontaktfeder trotz der entgegengesetzt gerichteten Anforderungen verlängert werden kann. Weiterhin soll ein Prüfsockel zur Aufnahme der erfindungsgemäßen Kontaktfedern geschaffen werden.

Gelöst wird die Aufgabe gemäß der Erfindung durch eine Kontaktfeder für einen Prüfsockels für die Strom-Prüfung, insbesondere Hochstrom-Prüfung, eines elektronischen Bauteils mit den Merkmalen von Anspruch 1 und einen Prüfsockel mit den Merkmalen von Anspruch 4. Weitere Einzelheiten und Vorteile der Erfindung ergeben sich aus den Unteransprüchen.

Gemäß einem Ausführungsbeispiel der Erfindung ist eine Kontaktfeder für einen Prüfsockel für die Strom-Prüfung, insbesondere Hochstrom-Prüfung, eines elektronischen Bauteils geschaffen, die aus einem Federblech vorbestimmter Stärke gefertigt ist und zwei, insbesondere identische, gegenüberliegende Seitenflächen besitzt, und die einen Federhebel und einen Prüfhebel mit Prüfspitze aufweist, wobei der Prüfhebel einen Winkel mit dem Federhebel bildet, der ein Aufsetzen der Prüfspitze auf eine in etwa parallel zu dem Federhebel verlaufende Kontaktfläche des elektronischen Bauteils durch eine Relativbewegung zwischen dem Prüfsockel und dem elektronischen

Bauteil ermöglicht, wobei die Geometrie der Seitenflächen folgende Bedingungen erfüllt:
- ein Maß des Abstands zwischen einem ersten Punkt und einem zweiten Punkt beträgt mindestens 2,3 mal einer Länge
- der erste Punkt liegt auf der dem elektronischen Bauteil zugewandten Begrenzungslinie der Seitenfläche und weist von der Prüfspitze einen Abstand von 3 mal bis 5 mal, insbesondere 4 mal, der Länge auf
- der erste Punkt bildet den Scheitelpunkt eines Winkels in einem Bereich zwischen 120° und 150°, insbesondere eines 135°-Winkels, dessen einer Schenkel sich in Richtung der Relativbewegung zwischen dem Prüfsockel und dem elektronischen Bauteil zu dem elektronischen Bauteil hin erstreckt und dessen anderer Schenkel die dem elektronischen Bauteil abgewandte Begrenzungslinie der Seitenfläche im zweiten Punkt schneidet
- die Länge entspricht der geringsten Dicke des Federhebels in Richtung der Relativbewegung zwischen Prüfsockel und elektronischem Bauteil gesehen.

Mit einer solchen Kontaktfedergeometrie kann die Standzeit der Kontaktfeder signifikant verlängert werden

Die Kontaktierung kann in der Funktionsprüfung von elektronischen Bauelementen eingesetzt werden (sogenannter Backend Test). Hierbei gibt es Anwendungen, bei denen kurzzeitig relativ viel Strom fließt, sodass sich die Kontaktfeder erwärmt. Speziell für diese Anwendungen, die sich auf einen eine merkliche Erwärmung (von zum Beispiel mindestens 10°C, insbesondere von zum Beispiel mindestens 30°C) der Kontaktfeder bewirkenden Hochstrom beziehen, sind Ausführungsbeispiele der Erfindung besonders vorteilhaft.

Die Seitenflächen einer Feder gemäß einem Ausführungsbeispiel der Erfindung können identisch sein (d.h. Ober- und Unterseite sind deckungsgleich), Wenngleich eine solche Feder besonders günstig fertigbar ist, ist auch eine Geometrie mit nicht deckungsgleichen Seitenflächen möglich.

Gemäß einem bevorzugten Ausführungsbeispiel erfüllt die Geometrie der Seitenflächen der Kontaktfeder folgende Bedingungen:
- das Maß L des Abstands zwischen einem Punkt Pₒ und einem Punkt Pᵤ beträgt mindestens 2,3 mal die Länge L1
- der Punkt Pₒ liegt auf der dem elektronischen Bauteil zugewandten Begrenzungslinie der Seitenfläche und weist von der Prüfspitze einen Abstand von 4 mal L1 auf
- der Punkt Pₒ bildet den Scheitelpunkt eines 135°-Winkels, dessen einer Schenkel sich in Richtung der Relativbewegung zwischen dem Prüfsockel und dem elektronischen Bauteil zu dem elektronischen Bauteil hin erstreckt und dessen anderer Schenkel die dem elektronischen Bauteil abgewandte Begrenzungslinie der Seitenfläche im Punkt Pᵤ schneidet
- die Länge L1 entspricht der geringsten Dicke des Federhebels, in Richtung der Relativbewegung zwischen Prüfsockel und elektronischem Bauteil gesehen.

Eine Aufgliederung der Kontaktfedern in einen Prüfhebel und einen Federhebel ist von der Form her nicht bei allen Kontaktfedern ohne weiteres möglich, da der Prüfhebel und der Federhebel oft ohne eindeutige Verbindungsstelle ineinander übergehen. Die Aufteilung soll daher funktionell verstanden werden: der Prüfhebel trägt die Prüfspitze, die auf die Kontaktfläche des elektronischen Bauteils aufsetzt und ist praktisch keiner elastischen Verformung unterworfen; der Federhebel wird dagegen bei jeder Kontaktierung elastisch verformt und bewegt sich in seine Ausgangsform zurück, sobald der Kontakt zwischen Prüfspitze und Kontaktfläche des elektronischen Bauteils wieder gelöst wird.

Die Kontaktfeder wird aus einem Federblech gefertigt und besitzt deshalb überall die gleiche Stärke. Eine Ausnahme kann hier nur die eigentliche Prüfspitze bilden, die entsprechend angefast sein kann. In der Seitenansicht von Federhebel und Prüfhebel ergibt sich eine Fläche mit einer punktförmigen Spitze und einer Ausbauchung im Verbindungsbereich von Federhebel und Prüfhebel.

Wie bereits weiter oben erläutert, hängt die Länge L1 der geringsten Dicke des Federhebels von der Materialstärke der Kontaktfeder ab, da die Federkraft, mit der die Prüfspitze auf die Kontaktfläche des elektronischen Bauteils gedrückt wird, in etwa immer gleich groß sein soll. Das bedeutet, dass die Stromfestigkeit einer Kontaktfeder mit einer geringeren Länge L1 aufgrund ihrer größeren Materialstärke normalerweise größer als die Stromfestigkeit einer Kontaktfeder mit einer größeren Länge L1 ist, da die Kontaktfeder mit der größeren Länge L1 eine geringere Materialstärke aufweist.

Da folglich die Länge L1 der geringsten Dicke des Federhebels in direktem Zusammenhang mit der Stromfestigkeit der Kontaktfeder steht, wurde dieser Wert als Basiswert für die erfindungsgemäße Lehre herangezogen.

Das Maß L für den Abstand zwischen dem Punkt Pₒ und dem Punkt Pᵤ ist ein Maß für die Größe der Seitenflächen der Kontaktfeder in einem bestimmten Abstand zur Prüfspitze. Mit dem angegebenem Maß L für den Abstand zwischen dem Punkt Pₒ und dem Punkt Pᵤ soll unter anderem eine vergrößerte Wärmekapazität definiert werden. Die Erhöhung der Wärmekapazität, die für eine vergrößerte Stromfestigkeit notwendig ist, kann nicht direkt an die Spitze der Kontaktfeder gesetzt werden, da hier die Platzverhältnisse dies nicht zulassen.

Die erhöhte Wärmekapazität darf aber auch nicht in einem zu großen Abstand von der Prüfspitze platziert werden, da sie dort nur eine geringe Wirkung entfalten könnte. Als ausgezeichneter Kompromiss zwischen diesen Anforderungen hat sich ein Abstand der erhöhten Wärmekapazität von der Prüfspitze herausgestellt, der der vierfachen Länge L1 der geringsten Dicke des Federhebels entspricht.

Der Federhebel der Kontaktfeder muss frei sein, um eine elastische Verformung des Federhebels zuzulassen, wenn die Prüfspitze auf die Kontaktflächen des elektronischen Bauteils gedrückt wird. Damit trotzdem eine stabile und positionsgenaue elektrische Verbindung der Kontaktfeder mit dem Prüfsockel gewährleistet ist, weist der Federhebel der Kontaktfeder an seiner dem Prüfhebel abgewandten Seite einen Lagerbereich auf, mit dem die Kontaktfeder in dem Prüfsockel verankert ist.

Die Kontaktfedern sind üblicherweise in Kunststoff gelagert. Da Kunststoff eine geringere Wärmefestigkeit als Metall besitzt, muss dafür gesorgt werden, dass die Temperatur der Kontaktfedern in ihrem Lagerbereich eine kritische Temperatur nicht überschreiten. Vorzugsweise wird deshalb im Lagerbereich der Kontaktfeder deren Oberfläche vergrößert. Hierzu weisen die Seitenflächen des Federhebels der Kontaktfeder im Lagerbereich der Kontaktfeder eine Aufweitung auf.

Es wird ein Prüfsockel für die Hochstrom-Prüfung eines elektronischen Bauteils vorgesehen, der die Kontakte des elektronischen Bauteils mit Kontaktfedern in leitende Verbindung bringt. Hierzu weist der Prüfsockel eine Vielzahl der erfindungsgemäßen Kontaktfedern auf.

Das zu prüfende elektronische Bauteil muss sowohl mit Schaltsignalen als auch mit den zu schaltenden Strömen beaufschlagt werden und es müssen die resultierenden Ströme gemessen werden. Für diesen Zweck sind für Kontakte des elektronischen Bauteils eine erste und eine zweite Kontaktfeder vorgesehen, die so angeordnet sind, dass ihre Seitenflächen jeweils in einer Ebene liegen.

Die Verdickung des Lagerbereichs des Federhebels erstreckt sich jeweils in die Richtung, die der jeweils anderen Kontaktfeder gegenüberliegt. Auf diese Weise können die paarweise angeordneten ersten und zweiten Kontaktfedern sehr eng verbaut werden und erreichen in ihrem Lagerbereich trotzdem eine Oberfläche, die eine gute Wärmeabgabe an den Prüfsockel ermöglicht. Die Temperatur der Kontaktfedern im Lagerbereich bleibt damit trotz der engen, paarweisen Anordnung in einem Bereich, der das Lagermaterial nicht schädigt.

Durch die Anordnung der paarweisen Kontaktfedern übereinander und die sehr nahe beieinander liegenden Prüfspitzen können die Seitenflächen der oberen ersten Kontaktfeder nicht genauso stark vergrößert werden wie die Seitenflächen der unteren zweiten Kontaktfeder. Besonders vorteilhaft beträgt deshalb das Maß L für den Abstand zwischen den Punkten Pₒ und Pᵤ bei der ersten oberen Kontaktfeder wenigstens 2,35 mal die Länge L1 und bei der zweiten unteren Kontaktfeder wenigstens 2,75 mal die Länge L1.

Weitere Einzelheiten und Vorteile der Erfindung ergeben sich aus der Beschreibung eines Ausführungsbeispiels, das anhand der Zeichnung eingehend erläutert wird.

Es zeigt:
- Fig. 1: einen erfindungsgemäßen Prüfsockel in perspektivischer Ansicht,
- Fig. 2: einen Schnitt durch den Prüfsockel,
- Fig. 3: die Seitenansicht eines erfindungsgemäßen Kontaktfedern-Paares aus oberer erster Kontaktfeder und unterer zweiter Kontaktfeder von der Prüfspitze bis zum Lagerbereich und
- Fig. 4: eine Seitenansicht der Prüfhebel aus Fig. 3 ohne Hilfslinien.

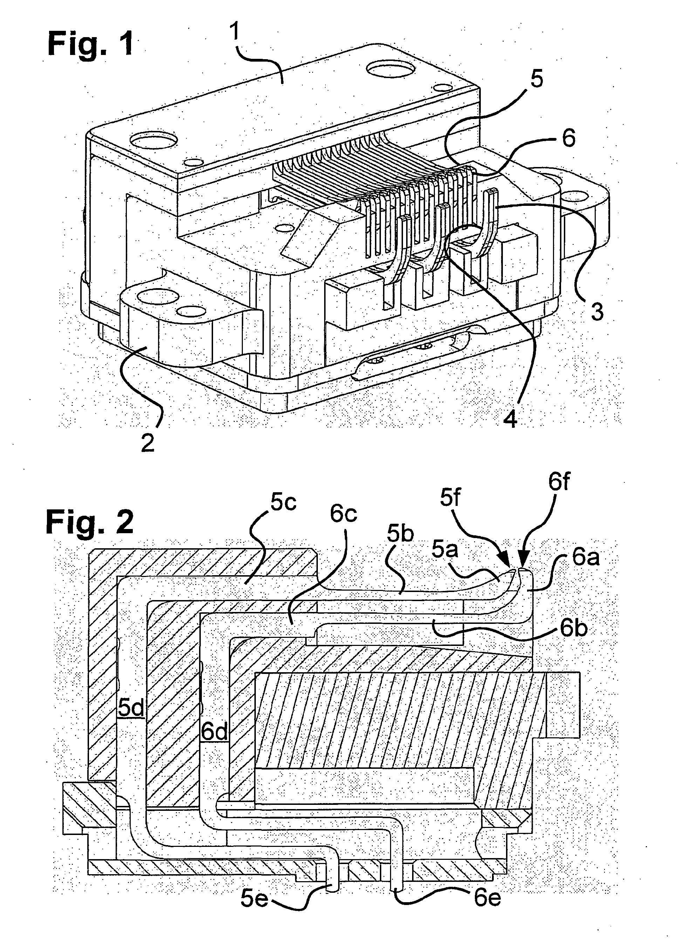

Der in Fig. 1 gezeigte Prüfsockel 1 ist für die Prüfung eines elektronischen Bauteils vorgesehen, welches in einer seiner Seitenflächen auf einer Seite zwölf Kontaktflächen und auf der anderen Seite drei Kontaktflächen besitzt. Die drei Kontaktflächen auf der einen Seite der Seitenfläche des elektronischen Bauteils werden über die Kontaktfeder-Paare 3, 4 kontaktiert, während die Kontaktfeder-Paare 5, 6 für die zwölf Kontaktflächen auf der anderen Seite der Seitenfläche des elektronischen Bauteils vorgesehen sind. Über die Befestigungen 2 wird der Prüfsockel positionsgenau an einem hier nicht gezeigten Testkopf fixiert.

Da es sich bei den Kontaktfedern 3, 4 und 5, 6 um Verschleißteile handelt, ist der Prüfsockel 1 so aufgebaut, dass er in relativ einfacher Weise geöffnet werden kann und die Kontaktfedern 3, 4 und 5, 6 problemlos ausgetauscht werden können.

Die bereits oben beschriebene Problematik der Strom- und Wärmefestigkeit der Kontaktfedern gilt insbesondere für die auf einen sehr begrenzten Raum konzentrierten Kontaktfeder-Paare 5, 6. Die Kontaktfeder-Paare 3, 4 weisen dagegen einen so großen Abstand voneinander auf, dass sie entsprechend ausgeformt werden können, so dass bei den Kontaktfeder-Paaren 3, 4 keine spezielle Lösung notwendig ist.

Der Querschnitt durch den Prüfsockel 1, wie er in Fig. 2 gezeigt ist, ist deshalb auf den Bereich beschränkt, der die Kontaktfeder-Paare 5, 6 enthält. Die Kontaktfedern 5 bzw. 6 weisen grundsätzlich einen Prüfhebel 5a, 6a und einen Federhebel 5b, 6b auf. Die Dimensionierung der Kontaktfedern 5, 6 bzw. die Verbindung zwischen Prüfhebel 5a, 6a und Federhebel 5b, 6b sind so gestaltet, dass die Kontaktfeder 5 oberhalb der Kontaktfeder 6 angebracht werden kann und die Prüfspitzen 5f, 6f trotzdem auf einer Höhe liegen und die gleiche Kontaktfläche des elektronischen Bauteils kontaktieren können.

Wie bereits oben erwähnt ist die Unterscheidung zwischen Prüfhebel 5a bzw. 6a und Federhebel 5b bzw. 6b nur aus funktioneller Sicht möglich. Die Aufgabe des Federhebels 5b bzw. 6b besteht darin, die Prüfspitze 5f bzw. 6f mit gleichbleibender Kraft an die Kontaktfläche des elektronischen Bauteils anzudrücken und nach dem Abheben von der Kontaktfläche wieder in ihre ursprüngliche Position zu bewegen. Der Federhebels 5b bzw. 6b wird folglich einer elastischen Verformung unterzogen. Der Prüfhebel 5a bzw. 6a soll sich nicht elastisch verformen. Er weist die Prüfspitze 5f bzw. 6f auf und soll diese exakt auf der Kontaktfläche des elektronischen Bauteils positionieren.

Der Federhebel 5b bzw. 6b geht an der dem Prüfhebel 5a bzw. 6a gegenüberliegenden Seite in den Lagerbereich 5c bzw. 6c über. Der Lagerbereich 5c bzw. 6c ist zwischen hier nicht näher bezeichneten Teilen aus Kunststoff eingespannt. Da die Wärmeabgabe in den Kunststoff geringer als die Wärmeabgabe in die Umgebungsluft ausfällt, ist die Oberfläche der Kontaktfedern in diesem Lagerbereich vergrößert. Damit der Abstand der beiden Kontaktfedern 5 und 6 von einander trotzdem gering gehalten werden kann, erstreckt sich eine Verdickung im Lagerbereich 5c, 6c immer in die von der jeweils anderen Kontaktfeder abgewandte Richtung.

In einem rechten Winkel schließt sich an das Lager 5c bzw. 6c ein Verbindungsteil 5d bzw. 6d an, welches die Aufgabe besitzt, eine elektrisch leitende Verbindung zu den Kontakten 5e bzw. 6e an der Unterseite des Prüfsockels 1 herzustellen. Diese Kontakte 5e, 6e stehen mit entsprechend geformten Kontaktstücken in dem hier nicht gezeigten Testkopf in Verbindung. Über die Kontaktfedern 5, 6 wird eine elektrisch leitende, mit geringen Verlusten behaftete Verbindung zwischen den Kontaktflächen des elektronischen Bauteils und dem Testkopf realisiert.

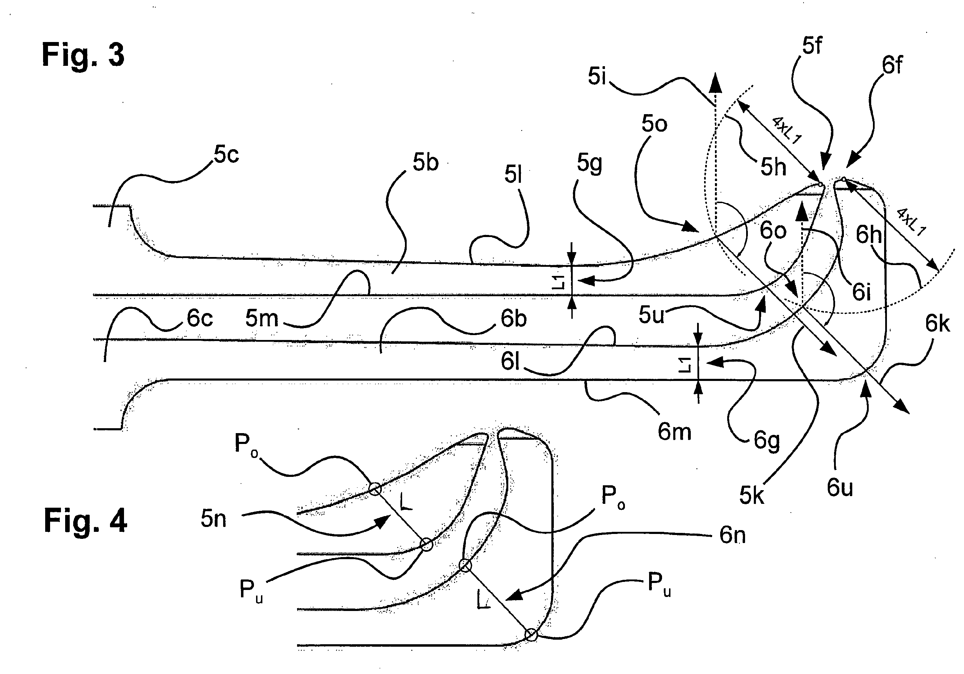

Die genaue Ausgestaltung der Kontaktfedern 5, 6 mit den Federhebeln 5b, 6b und den Prüfhebeln 5a, 6a ist den Figuren 3 und 4 zu entnehmen.

Es hat sich herausgestellt, dass die Standzeit der Kontaktfedern 5, 6 erhöht werden kann, wenn ihr Querschnitt und ihre Oberfläche vergrößert werden. Da die Materialstärke der Federn wegen der eng nebeneinander liegenden Kontaktflächen der elektronischen Bauteile nicht variabel ist, müssen die Kontaktfedern über die Gestaltung der Geometrie ihrer gegenüberliegenden Seitenflächen an diese Anforderungen angepasst werden.

Als ausschlaggebend für die Standzeit der Kontaktfedern gilt der Bereich des Prüfhebels 5a, 6a. Da hier eine erhöhte Wärmebelastung auftritt, sollte in diesem Bereich eine erhöhte Wärmekapazität geschaffen werden. Durch eine Vergrößerung der Prüfspitze selbst ist dies jedoch nicht möglich, da der zur Verfügung stehende Raum hier sehr begrenzt ist. Eine Erhöhung der Wärmekapazität muss folglich in einem Bereich der Kontaktfedern geschaffen werden, der möglichst nahe an der Prüfspitze liegt, aber weder den Bauraum der Prüfspitzen vergrößert, noch die Beweglichkeit der Kontaktfedern einschränkt. Auch soll aus der Erhöhung der Wärmekapazität keine gegenseitige Beeinflussung der elektrischen Eigenschaften dicht aneinander grenzender Kontaktfedern resultieren.

Es hat sich herausgestellt, dass eine Erhöhung der Wärmekapazität am besten in dem Verbindungsbereich zwischen Prüfhebel 5a, 6a und Federhebel 5b, 6b unterzubringen ist. Hier können die gegenüberliegenden Seitenflächen der Kontaktfedern, bei gleichbleibender Materialstärke, so vergrößert werden, dass genügend Wärme von der Prüfspitze abgezogen werden kann, so dass die Temperatur der Kontaktfedern in einem akzeptablen Rahmen bleibt. Dabei wird der Verbindungsbereich zwischen Prüfhebel und Federhebel so verdickt, dass einerseits eine entsprechende Wärmekapazität erreicht wird, dass sich die beiden Kontaktfedern 5 und 6 andererseits aber in ihrer Bewegung nicht gegenseitig beeinträchtigen.

Da die Kraft mit der die Kontaktfedern auf die Kontaktfläche des elektronischen Bauteils gedrückt werden in einem bestimmten Bereich liegen soll, richtet sich die geringste Dicke 5g, 6g des Federhebels 5b, 6b nach der Materialstärke der Kontaktfedern. Da aber auch die Materialstärke der Kontaktfedern einen Einfluss auf deren Wärmekapazität hat, wurde das Maß der geringsten Dicke des Federhebels zur Gestaltung des Verbindungsbereichs zwischen Prüfhebel und Federhebel verwendet.

Die Länge für die geringste Dicke 5g bzw. 6g des Federhebels 5b bzw. 6b ist hier mit L1 bezeichnet. Ausgehend von dieser Länge wird auf der oberen Begrenzungslinie 51 bzw. 61 der Seitenflächen der Kontaktfedern ein Punkt Pₒ festgelegt, der von der jeweiligen Prüfspitze 5f, bzw. 6f einen Abstand in der Größe von dem vierfachen Länge L1 der jeweiligen Kontaktfeder aufweist. Der Punkt Pₒ der Kontaktfeder 5 ist also definiert als Schnittpunkt 5o der oberen Begrenzungslinie 5l der Seitenfläche der Kontaktfeder 5 mit einem Kreisbogen 5h um die Prüfspitze 5f, der einen Radius von 4 mal L1 der Kontaktfeder 5 aufweist, während der Punkt Pₒ der Kontaktfeder 6 als Schnittpunkt 6o der oberen Begrenzungslinie 6l der Seitenfläche der Kontaktfeder 6 mit einem Kreisbogen 6h um die Prüfspitze 6f bestimmt ist, wobei der Kreisbogen 6h einen Radius von 4 mal L1 der Kontaktfeder 6 aufweist. Zur besseren Darstellung des Mittelpunkts des jeweiligen Kreisbogens 5h bzw. 6h ist die Prüfspitze 5f bzw. 6f in Fig. 3 jeweils als kleiner Kreis gezeichnet.

Die so bestimmten Schnittpunkte 5o und 6o sind Scheitelpunkte eines Winkels, dessen erster Schenkel 5i, bzw. 6i sich in die Richtung der Relativbewegung zwischen dem elektronischen Bauteil und dem Prüfsockel 1 erstreckt. Der zweite Schenkel 5k, bzw. 6k bildet mit dem ersten Schenkel 5i, 6i jeweils einen Winkel von 135°.

Durch die Schnittpunkte 5u und 6u der zweiten Schenkel 5k und 6k mit der jeweils unteren Begrenzungslinie 5m bzw. 6m der Seitenflächen der Kontaktfedern 5 und 6 werden die Punkte Pᵤ der beiden Kontaktfedern definiert.

In Fig. 4 sind die Punkte Pₒ und Pᵤ der beiden Kontaktfedern 5 und 6, die zur besseren Erkennbarkeit mit kleinen Kreisen umringt sind, aus Übersichtlichkeitsgründen nochmals ohne die Konstruktionslinien dargestellt. Zwischen den Punkten Pₒ und Pᵤ ergibt sich ein Abstand 5n bzw. 6n mit dem Maß L, das neben der Materialstärke spezifisch für die Wärme- und Stromfestigkeit der jeweiligen Kontaktfeder ist. Der Abstand mit dem Maß L ist ein Anhaltspunkt für die Ausbauchung in einem Bereich der Seitenfläche, der nicht zu weit von der Prüfspitze entfernt ist, die aber trotzdem sehr eng stehende Prüfspitzen zulässt und die Beweglichkeit der Kontaktfedern nicht behindert.

Erfindungsgemäß soll das Maß L des Abstands 5n, 6n wenigstens 2,3 mal die Länge L1 der geringsten Dicke des Federhebels betragen. Im hier gezeigten Ausführungsbeispiel mit zwei Kontaktfedern 5 und 6 beträgt das Maß L des Abstands 5n bei der oberen ersten Kontaktfeder 5 wenigstens das 2,35-Fache und das Maß L des Abstands 6n bei der unteren zweiten Kontaktfeder 6 wenigstens das 2,75-Fache der Länge L1 der jeweils geringsten Dicke 5g bzw. 6g. Die geringste Dicke 5g, 6g ist hier immer in Richtung der Relativbewegung zwischen dem hier nicht gezeigten elektronischen Bauteil und dem Prüfsockel gemeint, die auch durch die ersten Schenkel 5i und 6i in Fig. 3 aufgezeigt ist.

In dem gezeigten Ausführungsbeispiel besitzt der Federhebel der oberen Kontaktfeder 5 eine geringste Dicke 5g von L1 = 0,30 mm (nicht maßstabsgetreu gezeichnet). Das Maß L des Abstands 5n der Punkte Pₒ und Pᵤ liegt bei 0,72 mm, also dem 2,40-Fachen der Länge L1. Die untere Kontaktfeder 6 besitzt eine geringste Dicke 6g von L1 = 0,33 mm und das Maß L des Abstands 6n zwischen den Punkten Pₒ und Pᵤ beträgt 0,92 mm, also das 2,79-Fache der Länge L1.

### Bezugszeichenliste:

- 1: Prüfsockel
- 2: Befestigung
- 3: erste äußere Kontaktfeder
- 4: zweite äußere Kontaktfeder
- 5: obere Kontaktfeder
- 6: untere Kontaktfeder
a Prüfhebel
b Federhebel
c Lagerbereich
d Verbindungsteil
e Kontakt
f Prüfspitze
g geringste Dicke des Federhebels
h Kreisbogen um Prüfspitze
i erster Schenkel eines 135°-Winkels
k zweiter Schenkel eines 135°-Winkels
l obere Begrenzungslinie der Seitenfläche
m untere Begrenzungslinie der Seitenfläche
n Abstand zwischen Pₒ und Pᵤ
o Punkt Pₒ
u Punkt Pᵤ

## Patentansprüche

1. Kontaktfeder (5, 6) für einen Prüfsockel (1) für die Strom-Prüfung, insbesondere Hochstrom-Prüfung, eines elektronischen Bauteils, die aus einem Federblech vorbestimmter Stärke gefertigt ist und zwei, insbesondere identische, gegenüberliegende Seitenflächen besitzt, und die einen Federhebel (5b, 6b) und einen Prüfhebel (5a, 6a) mit Prüfspitze (5f, 6f) aufweist, wobei der Prüfhebel (5a, 6a) einen Winkel mit dem Federhebel (5b, 6b) bildet, der ein Aufsetzen der Prüfspitze (5f, 6f) auf eine in etwa parallel zu dem Federhebel (5b, 6b) verlaufende Kontaktfläche des elektronischen Bauteils durch eine Relativbewegung zwischen dem Prüfsockel (1) und dem elektronischen Bauteil ermöglicht, **dadurch gekennzeichnet, dass** die Geometrie der Seitenflächen folgende Bedingungen erfüllt:
• ein Maß L des Abstands (5n, 6n) zwischen einem Punkt Pₒ und einem Punkt Pᵤ beträgt mindestens 2,3 mal einer Länge L1 (5g, 6g)
• der Punkt Pₒ liegt auf der dem elektronischen Bauteil zugewandten Begrenzungslinie (51, 61) der Seitenfläche und weist von der Prüfspitze (5f, 6f) einen Abstand von 3 mal bis 5 mal, insbesondere 4 mal, der Länge L1 auf
• der Punkt Pₒ bildet den Scheitelpunkt eines Winkels in einem Bereich zwischen 120° und 150°, insbesondere eines 135°-Winkels, dessen einer Schenkel (5i, 6i) sich in Richtung der Relativbewegung zwischen dem Prüfsockel (1) und dem elektronischen Bauteil zu dem elektronischen Bauteil hin erstreckt und dessen anderer Schenkel (5k, 6k) die dem elektronischen Bauteil abgewandte Begrenzungslinie (5m, 6m) der Seitenfläche im Punkt Pᵤ schneidet
• die Länge L1 entspricht der geringsten Dicke (5g, 6g) des Federhebels (5b, 6b), in Richtung der Relativbewegung zwischen Prüfsockel (1) und elektronischem Bauteil gesehen.

2. Kontaktfeder nach Anspruch 1, **dadurch gekennzeichnet, dass** der Federhebel (5b, 6b) der Kontaktfeder (5, 6) an ihrer dem Prüfhebel (5a, 6a) abgewandten Seite einen Lagerbereich (5c, 6c) aufweist, mit dem sie in dem Prüfsockel (1) verankert ist.

3. Kontaktfeder nach Anspruch 2, **dadurch gekennzeichnet, dass** die Seitenflächen des Federhebels (5b, 6b) der Kontaktfeder (5, 6) im Lagerbereich (5c, 6c) der Kontaktfeder (5, 6) eine Aufweitung aufweist.

4. Prüfsockel für die Stromprüfung, insbesondere Hochstromprüfung, eines elektronischen Bauteils, **dadurch gekennzeichnet, dass** er eine Vielzahl der Kontaktfedern (5, 6) nach einem der Ansprüche 1 bis 3 aufweist.

5. Prüfsockel nach Anspruch 4, **dadurch gekennzeichnet, dass** für Kontaktflächen des elektronischen Bauteils eine erste (5) und eine zweite Kontaktfeder (6) vorgesehen sind, die so angeordnet sind, dass ihre Seitenflächen jeweils in einer Ebene liegen.

6. Prüfsockel nach Anspruch 5, **dadurch gekennzeichnet, dass** das Maß für den Abstand (5n, 6n) zwischen den Punkten Pₒ und Pᵤ bei der ersten Kontaktfeder (5) wenigstens 2,35 mal die Länge L1 und bei der zweiten Kontaktfeder (6) wenigstens 2,75 mal die Länge L1 beträgt.

## Claims

1. Contact spring (5, 6) for a test socket (1) for current testing, in particular high current testing, of an electronic component, which is made out of a spring steel sheet of a predetermined thickness and having two, in particular identical, opposing side faces, and comprising a spring lever (5b, 6b) and a test lever (5a, 6a) with a test tip (5f, 6f), wherein the test lever (5a, 6a) forms an angle with the spring lever (5b, 6b), which enables a setting of the test tip (5f, 6f) on a contact face of the electronic component running approximately parallel to the spring lever (5b, 6b) by a relative movement between the test socket (1) and the electronic component, **characterized in that** the geometry of the side faces fulfills the following conditions:
• a dimension L of the distance (5n, 6n) between a point Pₒ and a point Pᵤ is at least 2,3 times the length L1 (5g, 6g)
• the point Pₒ is located on the boundary line (5l, 6l) of the side face facing the electronic component and comprises a distance of 3 to 5 times, in particular 4 times, the length Ll
• the point Pₒ forms the apex of an angle in a range between 120° and 150°, in particular an angle of 135°, whose one arm (5i, 6i) extends in direction of the relative movement between the test socket (1) and the electronic component to the electronic component and whose other arm (5k, 6k) cuts the boundary line (5m, 6m) of the side facing away from the electronic component in the point Pᵤ
• the length L1 corresponds to the minimum thickness (5g, 6g) of the spring lever (5b, 6b), as viewed in direction of the relative movement between the test socket (1) and the electronic component.

2. Contact spring according to claim 1, **characterized in that** the spring lever (5b, 6b) of the contact spring (5, 6) comprises a bearing area (5c, 6c) on its side facing away from the test lever (5a, 6a), with which it is anchored in the test socket (1).

3. Contact spring according to claim 2, **characterized in that** the side faces of the spring lever (5b, 6b) of the contact spring (5, 6) comprises an enlargement in the bearing area (5c, 6c) of the contact spring (5, 6).

4. Test socket for current testing, in particular high current testing, of an electronic component, **characterized in that**, it comprises a plurality of the contact springs (5, 6) according to one of the claims 1 to 3.

5. Test socket according to claim 4, **characterized in that** a first (5) and a second contact spring (6) provided for the contact areas of the electronic component, which are arranged such that its side faces are each lying in a plane.

6. Test socket according to claim 5, **characterized in that** the dimension for the distance (5n, 6n) between the points Pₒ and Pᵤ is at the first contact spring (5) at least 2,35 times the length L1 and at the second contact spring at least 2,75 times the length L1.

## Revendications

1. Ressort de contact (5, 6) pour un socle de test (1) servant au test de courants, en particulier au test de forts courants, d'un composant électronique, qui est fabriqué à partir d'une tôle élastique d'une épaisseur prédéfinie et possède deux surfaces latérales en regard l'une de l'autre, en particulier identiques, et qui comprend un levier à ressort (5b, 6b) et un levier de test (5a, 6a) avec une pointe de test (5f, 6f), le levier de test (5a, 6a) formant avec le levier à ressort (5b, 6b) un angle qui permet une pose de la pointe de test (5f, 6f) sur une surface de contact du composant électronique, disposée à peu près parallèle au levier à ressort (5b, 6b), par un mouvement relatif entre le socle de test (1) et le composant électronique, **caractérisé en ce que** la géométrie des surfaces latérales satisfait les conditions suivantes :
- une cote L de l'écart (5n, 6n) entre un point Pₒ et un point Pᵤ est au moins 2,3 fois une longueur L1 (5g, 6g)
- le point Pₒ est situé sur la ligne frontière (51, 61) de la surface latérale tournée vers le composant électronique et présente un écart avec la pointe de test (5f, 6f) de 3 fois à 5 fois, en particulier 4 fois, la longueur L1
- le point Pₒ forme le sommet d'un angle dans une plage entre 120° et 150°, en particulier d'un angle de 135°, dont une branche (5i, 6i) s'étend en direction du mouvement relatif entre le socle de test (1) et le composant électronique par rapport au composant électronique et dont l'autre branche (5k, 6k) coupe au point Pu la ligne frontière (5m, 6m) de la surface latérale à l'opposé du composant électronique
- la longueur L1 correspond à la plus petite épaisseur (5g, 6g) du levier à ressort (5b, 6b), vu dans la direction du mouvement relatif entre le socle de test (1) et le composant électronique.

2. Ressort de contact selon la revendication 1, **caractérisé en ce que** le levier à ressort (5b, 6b) du ressort de contact (5, 6) comprend sur son côté opposé au levier de test (5a, 6a) une zone palier (5c, 6c) par laquelle il est ancré dans le socle de test (1).

3. Ressort de contact selon la revendication 2, **caractérisé en ce que** les surfaces latérales du levier à ressort (5b, 6b) du ressort de contact (5, 6) comprennent un élargissement dans la zone palier (5c, 6c) du ressort de contact (5, 6).

4. Socle de test servant au test de courants, en particulier au test de forts courants, d'un composant électronique, **caractérisé en ce qu'**il comprend une pluralité de ressorts de contact (5, 6) selon l'une quelconque des revendications 1 à 3.

5. Socle de test selon la revendication 4, **caractérisé en ce qu'**il est prévu, pour des surfaces de contact du composant électronique, un premier (5) et un second ressort de contact (6) qui sont disposés de sorte que leurs surfaces latérales soient chacune situées dans un plan.

6. Socle de test selon la revendication 5, **caractérisé en ce que** la cote pour l'écart (5n, 6n) entre les points Pₒ et Pu est au moins 2,35 fois la longueur L1 pour le premier ressort de contact (5) et au moins 2,75 fois la longueur L1 pour le second ressort de contact (6).
